# EUROPEAN PATENT APPLICATION

(11) **EP 3 498 468 A1**
(43) Date of publication of application: **19.06.2019**
(21) Application number: 17839308.8
(22) Date of filing: 02.08.2017
(51) Int. Cl.: B32B 9/00, B25J 15/00, B65G 49/07, B82Y 30/00, H01L 21/677

(54) **ADHESIVE STRUCTURE**

(30) Priority: 12.08.2016 JP 2016158633
(71) Applicant: Nitto Denko Corporation, Ibaraki-shi, Osaka 567-8680 (JP)
(72) Inventor: HATAKEYAMA Yoshiharu, Ibaraki-shi Osaka 567-8680 (JP); MASUDA Shotaro, Ibaraki-shi Osaka 567-8680 (JP); ICHIKAWA Tomoaki, Ibaraki-shi Osaka 567-8680 (JP); MAENO Yohei, Ibaraki-shi Osaka 567-8680 (JP)
(74) Representative: Müller-Boré & Partner Patentanwälte PartG mbB
(86) International application number: PCT/JP2017/028046
(87) International publication number: WO 2018/030235

(57) **Abstract**

Provided is a pressure-sensitive adhesive structure including a carbon nanotube aggregate formed on a base material in which carbon nanotubes forming the carbon nanotube aggregate are hardly detached. The pressure-sensitive adhesive structure of the present invention includes: a base material; an intermediate layer; and a carbon nanotube aggregate layer, wherein the carbon nanotube aggregate layer includes a plurality of carbon nanotube aggregates, wherein the intermediate layer includes a layer containing the carbon nanotubes and a fixing agent, and wherein the intermediate layer has a thickness of 100 nm or more.

## Description

### Technical Field

The present invention relates to a pressure-sensitive adhesive structure.

### Background Art

In transporting a material, a production intermediate, a product, or the like (hereinafter sometimes referred to as "object to be processed") in a manufacturing process for a semiconductor device or the like, the object to be processed is transported through use of a carrying member, such as a movable arm or a movable table (see, for example, Patent Literatures 1 and 2). In such transport, there is a demand for a member on which the object to be processed is to be mounted (fixing jig for transportation) to have such a strong gripping force as to prevent the object to be processed from shifting in position while being transported. In addition, such demand has increased year by year along with a demand for a faster manufacturing process.

However, in a related-art fixing jig for transportation, there is a problem in that the object to be processed is held by an elastic material, such as a resin, and hence the elastic material is liable to adhere to and remain on the object to be processed. In addition, there is a problem in that the elastic material, such as a resin, has low heat resistance, and hence the gripping force of the jig is reduced under a high-temperature environment.

When a material such as ceramics is used for the fixing jig for transportation, contamination of the object to be processed is prevented, and temperature dependence of a gripping force is reduced. However, a fixing jig for transportation formed of such material involves a problem of inherently having a weak gripping force, and thus being unable to sufficiently hold the object to be processed even at normal temperature.

In addition, a method of holding the object to be processed under a high-temperature environment is, for example, a method involving adsorbing the object to be processed under reduced pressure, or a method involving fixing the object to be processed by the shape of a fixing jig for transportation (e.g., chucking or counterbore fixing). However, the method involving adsorbing the object to be processed under reduced pressure is effective only under an air atmosphere, and cannot be adopted under a vacuum in, for example, a CVD step. In addition, the method involving fixing the object to be processed by the shape of the fixing jig for transportation involves, for example, the following problems. The object to be processed is damaged, or a particle is produced, by contact between the object to be processed and the fixing jig for transportation.

A possible method of solving such problems as described above is the use of a pressure-sensitive adhesive structure including a carbon nanotube aggregate as a fixing jig for transportation. The carbon nanotube aggregate is formed on a base material, and the pressure-sensitive adhesive structure includes the base material and the carbon nanotube aggregate. However, when the pressure-sensitive adhesive structure is used as the fixing jig for transportation, there is a problem in that carbon nanotubes forming the carbon nanotube aggregate are detached from the base material. The problem of the detachment of the carbon nanotubes becomes particularly remarkable in a fixing jig for transportation to be subjected to high-speed transport.

### Citation List

### Patent Literature

[PTL 1] JP 2001-351961 A
[PTL 2] JP 2013-138152 A

### Summary of Invention

### Technical Problem

An object of the present invention is to provide a pressure-sensitive adhesive structure including a carbon nanotube aggregate formed on a base material in which carbon nanotubes forming the carbon nanotube aggregate are hardly detached.

### Solution to Problem

According to one embodiment of the present invention, there is provided a pressure-sensitive adhesive structure, including: a base material; an intermediate layer; and a carbon nanotube aggregate layer, wherein the carbon nanotube aggregate layer includes a plurality of carbon nanotube aggregates, wherein the intermediate layer includes a layer containing the carbon nanotubes and a fixing agent, and wherein the intermediate layer has a thickness of 100 nm or more.

In one embodiment, the pressure-sensitive adhesive structure further includes a fixing agent layer between the base material and the intermediate layer.

In one embodiment, the fixing agent layer has a thickness of 1 µm or more.

In one embodiment, the fixing agent layer includes an adhesive containing inorganic matter.

In one embodiment, the adhesive containing inorganic matter includes an organic solvent-based ceramic adhesive.

In one embodiment, the inorganic matter includes an inorganic compound containing at least one kind of element selected from the group consisting of Al, Si, Ti, and K.

### Advantageous Effects of Invention

According to the present invention, the pressure-sensitive adhesive structure including a carbon nanotube aggregate formed on a base material in which carbon nanotubes forming the carbon nanotube aggregate are hardly detached can be provided.

### Brief Description of Drawings

FIG. **1** is a schematic sectional view of a pressure-sensitive adhesive structure according to one embodiment of the present invention.
FIG. **2** is a schematic sectional view of a pressure-sensitive adhesive structure according to another embodiment of the present invention.
FIG. **3** is a schematic sectional view of a fixing jig for transportation according to one embodiment of the present invention.
FIG. **4** is a schematic sectional view of a production apparatus for a carbon nanotube aggregate in one embodiment of the present invention.

### Description of Embodiments

### A. Outline of Pressure-sensitive Adhesive Structure

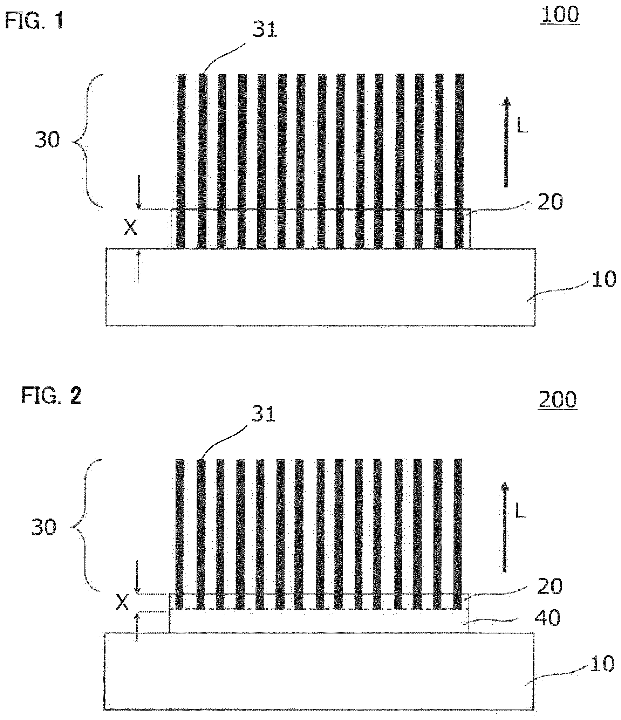

FIG. **1** is a schematic sectional view of a pressure-sensitive adhesive structure according to one embodiment of the present invention. A pressure-sensitive adhesive structure **100** includes a base material **10,** an intermediate layer **20,** and a carbon nanotube aggregate layer **30** in the stated order. The carbon nanotube aggregate layer **30** includes a plurality of carbon nanotubes **31.** The base material **10** and the carbon nanotubes **31** are bonded to each other with a fixing agent. The intermediate layer **20** is a layer containing the carbon nanotubes **31** and the fixing agent.

FIG. **2** is a schematic sectional view of a pressure-sensitive adhesive structure according to another embodiment of the present invention. Apressure-sensitive adhesive structure **200** further includes a fixing agent layer **40** between the base material **10** and the intermediate layer **20.** The fixing agent layer **40** is a layer containing the fixing agent. The fixing agent layer **40** is free of the carbon nanotubes **31.**

In one embodiment, the carbon nanotubes **31** forming the carbon nanotube aggregate layer **30** are each aligned in a substantially vertical direction (the direction of a length **L**), and the carbon nanotube aggregate layer **30** is formed as a fibrous columnar structure. The term "substantially vertical direction" as used herein means that an angle relative to the surface of the base material **10** is preferably 90°±20°, more preferably 90°±15°, still more preferably 90°±10°, particularly preferably 90°±5°.

In another embodiment, the carbon nanotubes in the carbon nanotube aggregate layer and/or the carbon nanotubes in the intermediate layer include an aligned portion and a non-aligned portion. The aligned portion and the non-aligned portion may be identified by: measuring the angles (alignment degrees) of 10 carbon nanotubes, which have been sampled at random in a division having a predetermined thickness (e.g., a thickness of 500 nm) in a sectional SEM image of a carbon nanotube aggregate (magnification: 20,000, image range: the thickness of the carbon nanotube aggregatexa width of about 6 µm), relative to the base material; and determining the standard deviation of the angles. In this description, a portion in which the standard deviation is 40° or more is defined as the non-aligned portion, and a portion in which the standard deviation is less than 40° is defined as the aligned portion. In this embodiment, the thickness of the non-aligned portion is preferably from 1 µm to 20 µm, more preferably from 2 µm to 10 µm, still more preferably from 2 µm to 7 µm.

In still another embodiment, the carbon nanotubes in the carbon nanotube aggregate layer and the intermediate layer are formed only of the non-aligned portion.

The pressure-sensitive adhesive structure of the present invention expresses a pressure-sensitive adhesive property by virtue of the action of the carbon nanotube aggregate layer. The coefficient of static friction of the carbon nanotube aggregate layer-side surface of the pressure-sensitive adhesive structure against a glass surface at 23 °C is preferably 1.0 or more. The upper limit value of the coefficient of static friction is preferably 50. When the coefficient of static friction falls within such range, a pressure-sensitive adhesive structure excellent in gripping property can be obtained. Needless to say, the pressure-sensitive adhesive structure having a large coefficient of friction against the glass surface can express a strong gripping property also against an object to be mounted (e.g., a semiconductor wafer) including a material except glass. The coefficient of static friction may be measured in conformity with JIS K7125.

The thickness **X** of the intermediate layer **30** is 100 nm or more. In the present invention, when the thickness of the intermediate layer is set within the range, a pressure-sensitive adhesive structure from which the carbon nanotubes are hardly detached can be obtained. The thickness of the intermediate layer is preferably 500 nm or more, more preferably 800 nm or more. In addition, the thickness of the intermediate layer is preferably 90% or less, more preferably 70% or less, still more preferably 50% or less of the thickness of the carbon nanotube aggregate layer. When the thickness of the intermediate layer falls within such range, a pressure-sensitive adhesive structure that can sufficiently express a pressure-sensitive adhesive property based on the carbon nanotube aggregate layer can be obtained. The thickness of the intermediate layer may be adjusted by, for example, the kind and characteristics (e.g., a viscosity, a modulus of elasticity, and hydrophilicity) of an adhesive or a pressure-sensitive adhesive forming a layer formed of the fixing agent (a precursor layer of the fixing agent layer to be described later), and process conditions at the time of the formation of the carbon nanotube aggregate layer (e.g., a load at the time of the formation of the carbon nanotube aggregate layer, details are described later) . The measurement of the thickness may be performed by observing a section of the pressure-sensitive adhesive structure with a SEM or the like. In addition, the thickness of the intermediate layer is the average of thicknesses measured at 7 points sampled at random in a portion inward from an end portion in the surface direction of the intermediate layer by 0.2 mm or more.

The carbon nanotubes in the intermediate layer preferably have anon-aligned portion. When the non-aligned portion of the carbon nanotubes is present in the intermediate layer, the above-mentioned effects become more significant.

The thickness of the carbon nanotube aggregate layer **30** is preferably from 10 µm to 5,000 µm, more preferably from 100 µm to 3,000 µm, still more preferably from 300 µm to 2,000 µm, particularly preferably from 400 µm to 1,500 µm, most preferably from 500 µm to 1,500 µm. The thickness of the carbon nanotube aggregate layer is, for example, the average of thicknesses measured at 7 points sampled at random in a portion inward from an end portion in the surface direction of the carbon nanotube aggregate layer by 0.2 mm or more.

When the pressure-sensitive adhesive structure of the present invention includes the fixing agent layer **40,** the thickness of the fixing agent layer **40** is preferably 1 µm or more, more preferably from 1 µm to 2,000 µm, still more preferably from 5 µm to 200 µm. In the present invention, when the fixing agent layer (layer that is free of the carbon nanotubes and contains the fixing agent) is formed while the intermediate layer containing the carbon nanotubes and the fixing agent is formed, a pressure-sensitive adhesive structure from which the carbon nanotubes are more hardly detached can be formed.

In one embodiment, the pressure-sensitive adhesive structure of the present invention is used as a fixing jig for transportation. The fixing jig for transportation may be suitably used in, for example, a manufacturing process for a semiconductor device or a manufacturing process for an optical member. In more detail, in the manufacturing process for a semiconductor device, the fixing jig for transportation may be used for transporting a material, a production intermediate, a product, or the like (specifically, a semiconductor material, a wafer, a chip, a substrate, a ceramic plate, a film, or the like) from one step to another or in a predetermined step. Alternatively, in the manufacturing process for an optical member, the fixing jig for transportation may be used for transporting a glass base material or the like from one step to another or in a predetermined step. A material, a production intermediate, a product, or the like that may be transported by the transport apparatus is hereinafter sometimes referred to as "object to be processed" or "object to be transported."

### B. Base Material

Any appropriate material may be adopted as a material forming the base material. In one embodiment, any one of the following materials is used as the material forming the base material: metal oxides, such as alumina and zirconia; carbides, such as silicon carbide; ceramic materials, such as silicon nitride and gallium nitride; heat-resistant materials, such as stainless steel; and heat-conductive materials or electroconductive materials, such as copper and aluminum. Of those, alumina is preferably used.

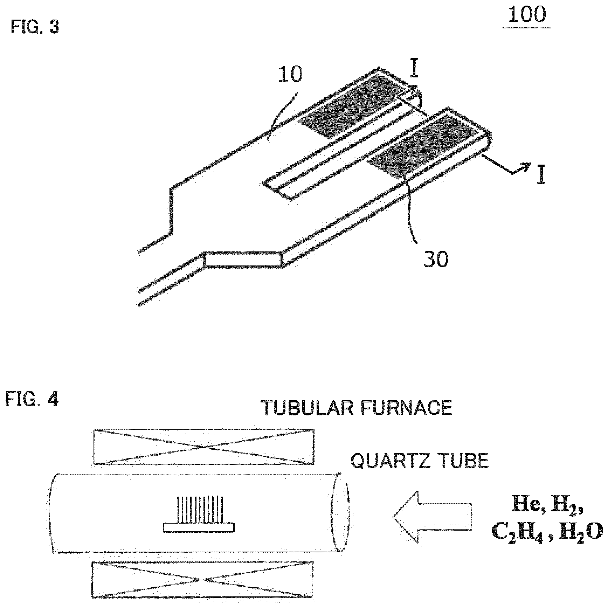

In one embodiment, when the pressure-sensitive adhesive structure of the present invention is used as a fixing jig for transportation, the base material functions as a transport base material at the time of the transport of a semiconductor material, an electronic material, or the like. In this case, examples of the form of the base material include a transport arm, a transport table, a transport ring, a transport guide rail, a storage cassette, a hook, and a transport frame. The size and shape of the base material may be appropriately selected in accordance with purposes. An example of a case in which the base material is a transport arm is illustrated in the schematic perspective view of FIG. **2****.** In the fixing jig for transportation **100** of FIG. **3****,** the carbon nanotube aggregate layer **30** is arranged on one end of the base material **10** serving as a transport arm.

### C. Intermediate Layer and Fixing Agent Layer

As described above, the intermediate layer contains the carbon nanotubes and the fixing agent. The intermediate layer maybe formed by incorporating at least part of the carbon nanotubes into a precursor layer of the fixing agent layer formed on the base material. The precursor layer of the fixing agent layer is a concept including a layer before the curing of the fixing agent (an applied layer of an adhesive or a pressure-sensitive adhesive) and a layer after the curing of the fixing agent. When at least part of the carbon nanotubes are incorporated into the entirety of the precursor layer of the fixing agent layer, a pressure-sensitive adhesive structure free of the fixing agent layer is obtained. In addition, when at least part of the carbon nanotubes are incorporated into part of the precursor layer of the fixing agent layer in its thickness direction, a pressure-sensitive adhesive structure including the fixing agent layer is obtained. The carbon nanotubes that have not been incorporated into the intermediate layer form the carbon nanotube aggregate layer.

The fixing agent layer may include any appropriate adhesive or pressure-sensitive adhesive. Any appropriate adhesive may be used as the adhesive as long as the effects of the present invention are obtained. Examples of the adhesive include a thermoplastic adhesive, a thermosetting adhesive, and a metal hot-melt adhesive. Examples of the thermosetting adhesive include an alkali metal silicate-based adhesive, a phosphate-based adhesive, a silica sol-based adhesive, a carbon-based adhesive, and a silicone-based adhesive. Any appropriate pressure-sensitive adhesive may be used as the pressure-sensitive adhesive as long as the effects of the present invention are obtained. Examples of the pressure-sensitive adhesive include an acrylic pressure-sensitive adhesive, a urethane-based pressure-sensitive adhesive, a silicone-based pressure-sensitive adhesive, and a rubber-based pressure-sensitive adhesive.

In one embodiment, the fixing agent layer includes an adhesive containing inorganic matter. An aqueous ceramic adhesive or an organic solvent-based ceramic adhesive is preferably used as the adhesive containing inorganic matter. Those adhesives are preferred because each of the adhesives facilitates the control of the thickness of the intermediate layer and is excellent in heat resistance. In addition, the aqueous ceramic adhesive is preferred because the adhesive may form an adhesive layer having higher heat resistance. In addition, the organic solvent-based ceramic adhesive is preferred because of its excellent affinity for the carbon nanotubes.

The aqueous ceramic adhesive is an adhesive that can express an adhesive property through the curing of a curable component, such as an alkali metal silicate, a phosphate, or a metal alkoxide. An aqueous ceramic adhesive containing an alkali metal silicate or a phosphate (e.g., aluminum phosphate) as a curable component is preferably used.

The aqueous ceramic adhesive may further contain a curing agent (curing accelerator) and/or a filler. In addition, the aqueous ceramic adhesive may contain any appropriate dispersion medium (e.g., water).

Examples of the curing agent (curing accelerator) to be used in combination with the alkali metal silicate include: oxides or hydroxides of zinc, magnesium, and calcium; silicides of sodium, potassium, and calcium; phosphates of aluminum and zinc; and borates of calcium, barium, and magnesium. Examples of the curing agent (curing accelerator) to be used in combination with the phosphate include: oxides or hydroxides of magnesium, calcium, zinc, and aluminum; silicates of magnesium and calcium; and Group II borates .

Examples of the filler include: metal oxides, such as alumina, silica, zirconia, zinc oxide, magnesium oxide, titania, and ceria; metal composite oxides, such as potassium titanate, strontium titanate, barium titanate, and barium sulfate; and nitrides, such as aluminum nitride, boron nitride, silicon nitride, and gallium nitride.

The organic solvent-based ceramic adhesive contains, for example, inorganic matter, a binder, and an organic solvent. An example of the inorganic matter is the filler. Examples of the binder include: metal alkoxides; and silicone-based resins, such as organopolysiloxane.

The inorganic matter in the organic solvent-based ceramic adhesive is preferably formed of an inorganic compound containing at least one kind of element selected from the group consisting of Al, Si, Ti, and K. Examples of the inorganic compound include: oxides, such as alumina, silicon dioxide, and titanium dioxide; metal composite oxides, such as potassium titanate; nitrides, such as aluminum nitride and silicon nitride; carbides, such as silicon carbide; and phosphor materials each obtained by doping yttrium or the like into a garnet structure of alumina.

A volatile organic solvent (e.g., an organic solvent having a boiling point of less than 150°C) may be used as the organic solvent in the organic solvent-based ceramic adhesive, or a nonvolatile organic solvent (e.g., an organic solvent having a boiling point of 150°C or more, preferably 200°C or more) may be used. In one embodiment, the nonvolatile organic solvent is used. In the case where the pressure-sensitive adhesive structure is formed through the steps of: (i) applying an adhesive (adhesive containing a solvent and the above-mentioned respective components) onto the base material to form an applied layer; (ii) arranging the carbon nanotube aggregate on the applied layer; and (iii) drying the applied layer, when an adhesive containing the nonvolatile organic solvent is used, unnecessary volatilization of the solvent during a period from the step (i) to the step (ii) is reduced. Accordingly, a fixing agent layer and an intermediate layer having desired thicknesses can be formed while the application amount of the adhesive (substantially the application amount of the solvent) is reduced. In addition, when the application amount of the adhesive is reduced, the infiltration (e.g., infiltration by capillarity) of the adhesive into the carbon nanotube aggregate in the step (ii) can be prevented. As a result, an intermediate layer excellent in thickness uniformity can be obtained. Examples of the nonvolatile organic solvent include ethers, such as butyl diglycol ether and diethylene glycol dibutyl ether.

### D. Carbon Nanotube Aggregate Layer

The carbon nanotube aggregate layer includes a plurality of carbon nanotubes.

For the carbon nanotubes forming the carbon nanotube aggregate layer, for example, the following embodiments (a first embodiment and a second embodiment) may be adopted.

A first embodiment of the carbon nanotube aggregate layer includes a plurality of carbon nanotubes, in which the carbon nanotubes each have a plurality of walls, the distribution width of the wall number distribution of the carbon nanotubes is 10 walls or more, and the relative frequency of the mode of the wall number distribution is 25% or less. When the carbon nanotube aggregate adopts such configuration, a pressure-sensitive adhesive structure that has a high gripping force and is excellent in cleanliness can be formed.

In the first embodiment, the distribution width of the wall number distribution of the carbon nanotubes is preferably 10 walls or more, more preferably from 10 walls to 30 walls, still more preferably from 10 walls to 25 walls, particularly preferably from 10 walls to 20 walls. When the distribution width of the wall number distribution of the carbon nanotubes is adjusted to fall within such range, a pressure-sensitive adhesive structure that has a high gripping force and is excellent in cleanliness can be formed.

The "distribution width" of the wall number distribution of the carbon nanotubes refers to a difference between the maximum wall number and minimum wall number of the wall numbers of the carbon nanotubes. When the distribution width of the wall number distribution of the carbon nanotubes is adjusted to fall within the above-mentioned range, the carbon nanotubes can have both excellent mechanical properties and a high specific surface area, and moreover, the carbon nanotubes can provide a carbon nanotube aggregate exhibiting an excellent pressure-sensitive adhesive property.

The wall number and wall number distribution of the carbon nanotubes may each be measured with any appropriate device. The wall number and wall number distribution of the carbon nanotubes are each preferably measured with a scanning electron microscope (SEM) or a transmission electron microscope (TEM). For example, at least 10, preferably 20 or more carbon nanotubes may be taken out from the carbon nanotube aggregate to evaluate the wall number and the wall number distribution by the measurement with the SEM or the TEM.

In the first embodiment, the maximum wall number of the wall numbers of the carbon nanotubes is preferably from 5 to 30, more preferably from 10 to 30, still more preferably from 15 to 30, particularly preferably from 15 to 25. When the maximum wall number of the wall numbers of the carbon nanotubes is adjusted to fall within such range, a pressure-sensitive adhesive structure that has a high gripping force and is excellent in cleanliness can be formed.

In the first embodiment, the minimum wall number of the wall numbers of the carbon nanotubes is preferably from 1 to 10, more preferably from 1 to 5. When the minimum wall number of the wall numbers of the carbon nanotubes is adjusted to fall within such range, a pressure-sensitive adhesive structure that has a high gripping force and is excellent in cleanliness can be formed.

In the first embodiment, when the maximum wall number and minimum wall number of the wall numbers of the carbon nanotubes are adjusted to fall within the above-mentioned ranges, the carbon nanotubes can have both excellent mechanical properties and a high specific surface area, and moreover, the carbon nanotubes can provide a carbon nanotube aggregate exhibiting an excellent pressure-sensitive adhesive property.

In the first embodiment, the relative frequency of the mode of the wall number distribution of the carbon nanotubes is preferably 25% or less, more preferably from 1% to 25%, still more preferably from 5% to 25%, particularly preferably from 10% to 25%, most preferably from 15% to 25%. When the relative frequency of the mode of the wall number distribution of the carbon nanotubes is adjusted to fall within the above-mentioned range, the carbon nanotubes can have both excellent mechanical properties and a high specific surface area, and moreover, the carbon nanotubes can provide a carbon nanotube aggregate exhibiting an excellent pressure-sensitive adhesive property.

In the first embodiment, the mode of the wall number distribution of the carbon nanotubes is present at preferably from 2 walls to 10 walls in number, more preferably from 3 walls to 10 walls in number. When the mode of the wall number distribution of the carbon nanotubes is adjusted to fall within the above-mentioned range, the carbon nanotubes can have both excellent mechanical properties and a high specific surface area, and moreover, the carbon nanotubes can provide a carbon nanotube aggregate exhibiting an excellent pressure-sensitive adhesive property.

In the first embodiment, regarding the shape of each of the carbon nanotubes, the lateral section of the carbon nanotube only needs to have any appropriate shape. The lateral section is of, for example, a substantially circular shape, an oval shape, or an n-gonal shape (n represents an integer of 3 or more).

In the first embodiment, the diameter of each of the carbon nanotubes is preferably from 0.3nm to 2,000nm, more preferably from 1 nm to 1,000 nm, still more preferably from 2 nm to 500 nm. When the diameter of each of the carbon nanotubes is adjusted to fall within the above-mentioned range, the carbon nanotubes can have both excellent mechanical properties and a high specific surface area, and moreover, the carbon nanotubes can provide a carbon nanotube aggregate exhibiting an excellent pressure-sensitive adhesive property.

In the first embodiment, the specific surface area and density of each of the carbon nanotubes may be set to any appropriate values.

The second embodiment of the carbon nanotube aggregate includes a plurality of carbon nanotubes, in which the carbon nanotubes each have a plurality of walls, the mode of the wall number distribution of the carbon nanotubes is present at 10 walls or less in number, and the relative frequency of the mode is 30% or more. When the carbon nanotube aggregate adopts such configuration, a pressure-sensitive adhesive structure that has a high gripping force and is excellent in cleanliness can be formed.

In the second embodiment, the distribution width of the wall number distribution of the carbon nanotubes is preferably 9 walls or less, more preferably from 1 wall to 9 walls, still more preferably from 2 walls to 8 walls, particularly preferably from 3 walls to 8 walls. When the distribution width of the wall number distribution of the carbon nanotubes is adjusted to fall within such range, a pressure-sensitive adhesive structure that has a high gripping force and is excellent in cleanliness can be formed.

In the second embodiment, the maximum wall number of the wall numbers of the carbon nanotubes is preferably from 1 to 20, more preferably from 2 to 15, still more preferably from 3 to 10. When the maximum wall number of the wall numbers of the carbon nanotubes is adjusted to fall within such range, apressure-sensitive adhesive structure that has a high gripping force and is excellent in cleanliness can be formed.

In the second embodiment, the minimum wall number of the wall numbers of the carbon nanotubes is preferably from 1 to 10, more preferably from 1 to 5. When the minimum wall number of the wall numbers of the carbon nanotubes is adjusted to fall within such range, a pressure-sensitive adhesive structure that has a high gripping force and is excellent in cleanliness can be formed.

In the second embodiment, when the maximum wall number and minimum wall number of the wall numbers of the carbon nanotubes are adjusted to fall within the above-mentioned ranges, the carbon nanotubes can have both excellent mechanical properties and a high specific surface area, and moreover, the carbon nanotubes can provide a carbon nanotube aggregate exhibiting an excellent pressure-sensitive adhesive property.

In the second embodiment, the relative frequency of the mode of the wall number distribution of the carbon nanotubes is preferably 30% or more, more preferably from 30% to 100%, still more preferably from 30% to 90%, particularly preferably from 30% to 80%, most preferably from 30% to 70%. When the relative frequency of the mode of the wall number distribution of the carbon nanotubes is adjusted to fall within the above-mentioned range, the carbon nanotubes can have both excellent mechanical properties and a high specific surface area, and moreover, the carbon nanotubes can provide a carbon nanotube aggregate exhibiting an excellent pressure-sensitive adhesive property.

In the second embodiment, the mode of the wall number distribution of the carbon nanotubes is present at preferably 10 walls or less in number, more preferably from 1 wall to 10 walls in number, still more preferably from 2 walls to 8 walls in number, particularly preferably from 2 walls to 6 walls in number. When the mode of the wall number distribution of the carbon nanotubes is adjusted to fall within the above-mentioned range, the carbon nanotubes can have both excellent mechanical properties and a high specific surface area, and moreover, the carbon nanotubes can provide a carbon nanotube aggregate exhibiting an excellent pressure-sensitive adhesive property.

In the second embodiment, regarding the shape of each of the carbon nanotubes, the lateral section of the carbon nanotube only needs to have any appropriate shape. The lateral section is of, for example, a substantially circular shape, an oval shape, or an n-gonal shape (n represents an integer of 3 or more).

In the second embodiment, the diameter of each of the carbonnanotubes is preferably from 0.3 nm to 2, 000 nm, more preferably from 1 nm to 1,000 nm, still more preferably from 2 nm to 500 nm. When the diameter of each of the carbon nanotubes is adjusted to fall within the above-mentioned range, the carbon nanotubes can have both excellent mechanical properties and a high specific surface area, and moreover, the carbon nanotubes can provide a carbon nanotube aggregate exhibiting an excellent pressure-sensitive adhesive property.

In the second embodiment, the specific surface area and density of the carbon nanotubes may be set to any appropriate values.

In one embodiment, at least part of the carbon nanotubes each have a portion including at least an end thereof covered with an inorganic material. The term "portion including at least an end" as used herein means a portion including at least an end of a carbon nanotube, that is, the end of the carbon nanotube on a side opposite to the base material.

All of the carbon nanotubes may each have a portion including at least an end thereof covered with the inorganic material, or part of the carbon nanotubes may each have a portion including at least an end thereof covered with the inorganic material. The content of the carbon nanotubes each having a portion including at least an end thereof covered with the inorganic material in the entirety of the plurality of carbon nanotubes is preferably from 50 wt% to 100 wt%, more preferably from 60 wt% to 100 wt%, still more preferably from 70 wt% to 100 wt%, even still more preferably from 80 wt% to 100 wt%, particularly preferably from 90 wt% to 100 wt%, most preferably substantially 100 wt%. When the content falls within such range, a pressure-sensitive adhesive structure that has a high gripping force and is excellent in cleanliness can be formed.

The thickness of the covering layer is preferably 1 nm or more, more preferably 3 nm or more, still more preferably 5 nm or more, even still more preferably 7 nm or more, particularly preferably 9 nm or more, most preferably 10 nm or more. An upper limit value for the thickness of the covering layer is preferably 50nm, more preferably 40 nm, still more preferably 30 nm, particularly preferably 20 nm, most preferably 15 nm. When the thickness falls within such range, a pressure-sensitive adhesive structure that has a high gripping force and is excellent in cleanliness can be formed.

The length of the covering layer is preferably from 1 nm to 1,000 nm, more preferably from 5 nm to 700 nm, still more preferably from 10 nm to 500 nm, particularly preferably from 30 nm to 300 nm, most preferably from 50 nm to 100 nm. When the length falls within such range, a pressure-sensitive adhesive structure that has a high gripping force and is excellent in cleanliness can be formed.

Any appropriate inorganic material may be adopted as the inorganic material to the extent that the effects of the present invention are not impaired. Examples of such inorganic material include SiO₂, Al₂O₃, Fe₂O₃, TiO₂, MgO, Cu, Ag, and Au.

Any appropriate method may be adopted as a method of producing the carbon nanotube aggregate.

The method of producing the carbon nanotube aggregate is, for example, a method of producing a carbon nanotube aggregate aligned substantially perpendicularly from a flat plate by chemical vapor deposition (CVD) involving forming a catalyst layer on the flat plate and filling a carbon source under a state in which a catalyst is activated with heat, plasma, or the like to grow the carbon nanotubes.

Any appropriate flat plate may be adopted as the flat plate that may be used in the method of producing the carbon nanotube aggregate. The flat plate is, for example, a material having smoothness and high-temperature heat resistance enough to resist the production of the carbon nanotubes. Examples of such material include: metal oxides, such as quartz glass, zirconia, and alumina; metals, such as silicon (e.g., a silicon wafer), aluminum, and copper; carbides, such as silicon carbide; and nitrides, such as silicon nitride, aluminum nitride, and gallium nitride.

Any appropriate apparatus maybe adopted as an apparatus for producing the carbon nanotube aggregate. The apparatus is, for example, a thermal CVD apparatus of a hot wall type formed by surrounding a cylindrical reaction vessel with a resistance heating electric tubular furnace as illustrated in FIG. 3. In this case, for example, a heat-resistant quartz tube is preferably used as the reaction vessel.

Any appropriate catalyst may be used as the catalyst (material for the catalyst layer) that may be used in the production of the carbon nanotube aggregate. Examples of the catalyst include metal catalysts, such as iron, cobalt, nickel, gold, platinum, silver, and copper.

In the production of the carbon nanotube aggregate, an alumina/hydrophilic film, a metal film, a metal oxide film, or the like may be formed between the flat plate and the catalyst layer as required.

Any appropriate method may be adopted as a method of producing the alumina/hydrophilic film. For example, the film is obtained by producing a SiO₂ film on the flat plate, depositing Al from the vapor, and then increasing the temperature of Al to 450°C to oxidize Al. According to such production method, Al₂O₃ interacts with the hydrophilic SiO₂ film, and hence an Al₂O₃ surface different from that obtained by directly depositing Al₂O₃ from the vapor in particle diameter is formed. When Al is deposited from the vapor, and then its temperature is increased to 450°C so that Al may be oxidized without the production of any hydrophilic film on the flat plate, it may be difficult to form the Al₂O₃ surface having a different particle diameter. In addition, when the hydrophilic film is produced on the flat plate and Al₂O₃ is directly deposited from the vapor, it may also be difficult to form the Al₂O₃ surface having a different particle diameter.

The thickness of the catalyst layer that may be used in the production of the carbon nanotube aggregate is preferably from 0.01 nm to 20 nm, more preferably from 0.1 nm to 10 nm in order to form fine particles. When the thickness of the catalyst layer that may be used in the production of the carbon nanotube aggregate is adjusted to fall within the above-mentioned range, the carbon nanotubes to be formed can have both excellent mechanical properties and a high specific surface area, and moreover, the carbon nanotubes can provide a carbon nanotube aggregate exhibiting an excellent pressure-sensitive adhesive property.

Any appropriate method may be adopted as a method of forming the catalyst layer. Examples of the method include a method involving depositing a metal catalyst from the vapor, for example, with an electron beam (EB) or by sputtering and a method involving applying a suspension of metal catalyst fine particles onto the flat plate.

Any appropriate carbon source may be used as the carbon source that may be used in the production of the carbon nanotube aggregate. Examples thereof include: hydrocarbons, such as methane, ethylene, acetylene, and benzene; and alcohols, such as methanol and ethanol.

Any appropriate temperature may be adopted as a production temperature in the production of the carbon nanotube aggregate. For example, the temperature is preferably from 400°C to 1,000°C, morepreferably from 500°C to900°C, still more preferably from 600°C to 800°C in order that catalyst particles allowing sufficient expression of the effect of the present invention may be formed.

In one embodiment, the following procedure is followed: as described above, the catalyst layer is formed on the flat plate, and under a state in which the catalyst is activated, the carbon source is supplied to grow the carbon nanotubes; and then, the supply of the carbon source is stopped, and the carbon nanotubes are maintained at a reaction temperature under a state in which the carbon source is present. In one embodiment, the formation of the carbon nanotubes having the non-aligned portion can be controlled by conditions for the reaction temperature-maintaining step.

In one embodiment, the following procedure may be followed: as described above, the catalyst layer is formed on the flat plate, and under a state in which the catalyst is activated, the carbon source is supplied to grow the carbon nanotubes; and then, a predetermined load is applied in the thickness direction of each of the carbon nanotubes on the flat plate to compress the carbon nanotubes. According to such procedure, carbon nanotubes formed only of a non-aligned portion can be obtained. The load is, for example, from 1 g/cm² to 10,000 g/cm², preferably from 5 g/cm² to 1,000 g/cm², more preferably from 100 g/cm² to 500 g/cm². In one embodiment, the ratio of the thickness of the carbon nanotube aggregate layer after the compression to the thickness of the carbon nanotube aggregate layer before the compression is from 10% to 90% (preferably from 20% to 80%, more preferably from 30% to 60%).

### E. Method of producing Pressure-sensitive Adhesive Structure

The pressure-sensitive adhesive structure may be produced by any appropriate method. In one embodiment, the pressure-sensitive adhesive structure may be obtained by: applying the adhesive or the pressure-sensitive adhesive forming the fixing agent layer onto the base material; arranging the carbon nanotube aggregate on an applied layer formed by the application; and then curing the applied layer to form an adhesive layer or a pressure-sensitive adhesive layer. In addition, the pressure-sensitive adhesive structure may be produced by: forming the fixing agent layer including the pressure-sensitive adhesive on the base material; and embedding part of the carbon nanotube aggregate in the fixing agent layer. A method of arranging the carbon nanotube aggregate on the applied layer is, for example, a method involving transferring the carbon nanotube aggregate from the flat plate with a carbon nanotube aggregate obtained by the method described in the section D onto the applied layer.

Any appropriate method may be adopted as a method of applying the adhesive or the pressure-sensitive adhesive. Examples of the application method include application with a comma coater or a die coater, application with a dispenser, and application with a squeegee.

The viscosity of the applied layer at the time of the arrangement of the carbon nanotube aggregate is preferably from 0.005 Pa·s to 200 Pa·s, more preferably from 0.05 Pa·s to 50 Pa·s. When the viscosity falls within such range, a pressure-sensitive adhesive structure in which the thickness of the intermediate layer is appropriately adjusted can be obtained.

After the carbon nanotube aggregate has been arranged on the applied layer or the fixing agent layer including the pressure-sensitive adhesive, a load is preferably applied to the surface of the carbon nanotube aggregate opposite to the applied layer or the fixing agent layer at any appropriate timing. The application of the load can control the thicknesses of the intermediate layer and the fixing agent layer. The load is, for example, from 5 g/cm² to 300 g/cm². The timing at which the load is applied is, for example, timing before the drying of the applied layer or timing before the start of the curing treatment of the applied layer.

Any appropriate method may be adopted as a method of curing the applied layer. A method involving curing the layer through heating is preferably used. A curing temperature may be appropriately set in accordance with the kind of the adhesive or the pressure-sensitive adhesive. The curing temperature is, for example, from 50°C to 400°C. In one embodiment, in accordance with the kind of the adhesive or the pressure-sensitive adhesive (for example, when an organic solvent-based ceramic adhesive is used), the layer may be calcined under high temperature after the curing. A calcination temperature is preferably higher than the use temperature of the adhesive or the pressure-sensitive adhesive, and is, for example, 200°C or more, preferably from 350°C to 3, 000°C. In one embodiment, the vertical adhesive strength of the pressure-sensitive adhesive structure at 24°C after the calcination at 400°C for 2 hours is 3 N/cm² or more (preferably 5 N/cm² or more). Such pressure-sensitive adhesive structure may be obtained by, for example, using an organic solvent-based ceramic adhesive as the adhesive. The vertical adhesive strength is measured by pulling the pressure-sensitive adhesive structure in a vertical direction (direction perpendicular to the main surface of the pressure-sensitive adhesive structure) at a rate of 50 mm/min through a predetermined measuring jig, and the strength corresponds to a strength at the time of the breakage of the pressure-sensitive adhesive structure. A breaking mode based on the test includes breakage at an interface between the respective layers of the structure and peeling in each of the layers. For example, a tensile tester (TG-1kN: manufactured by Minebea Co., Ltd.) and a load cell (TT3D-50N: manufactured by Minebea Co., Ltd.) are used in the tensile test. For example, a product obtained by attaching a film having a predetermined length to the protruding portion (pin) side of a pin stub (made of aluminum, flat portion: φ12.5 mm) may be used as the measuring jig. Specifically, the measuring jig may be obtained by: bonding a double-sided pressure-sensitive adhesive tape to one end (10 mm×10 mm) of each of two films (each measuring 10 mm wide by 120 mm long); and sandwiching the protruding portion (pin) of a pin stub (manufactured by EM Japan Co., Ltd.) between the double-sided pressure-sensitive adhesive tape portions to fix the pin stub to the films. The tensile test is performed by preparing two such measuring jigs as described above, and pulling the pressure-sensitive adhesive structure from both of its surfaces with the jigs. That is, the vertical adhesive strength may be measured after the flat portion (pedestal portion) of the measuring jig has been fixed to each of both surfaces of the pressure-sensitive adhesive structure, and sides opposite to the sides of the films of the measuring jig having attached thereto the pin stub have been chucked with the tensile tester. Double-sided pressure-sensitive adhesive tapes may be used in the fixing of the pressure-sensitive adhesive structure and the measuring jigs (substantially the flat portions of the pin stubs).

Now, the present invention is described by way of Examples. However, the present invention is not limited thereto. Various evaluations and measurements were performed by the following methods.

### (1) Measurement of Layer Thickness

A section of a pressure-sensitive adhesive structure was observed with a SEM, and the thickness of each of its layers was measured.

### (2) Durability Test

A semiconductor wafer made of silicon was fixed on a stage reciprocating in a linear direction, and a pressure-sensitive adhesive structure was mounted on the semiconductor wafer made of silicon. At this time, the carbon nanotube aggregate surface of the pressure-sensitive adhesive structure was brought into contact with the semiconductor wafer.

Next, the stage was reciprocated 100 times at an acceleration of 1 G, and the state of the damage of the pressure-sensitive adhesive structure (the state of the detachment of its carbon nanotube aggregate) after the reciprocation was visually observed.

### [Production Example 1] Production of Carbon Nanotube Aggregate

An Al₂O₃ thin film (ultimate vacuum: 8.0×10⁻⁴ Pa, sputtering gas: Ar, gas pressure: 0.50 Pa, growth rate: 0.12 nm/sec, thickness: 20 nm) was formed on a flat plate made of silicon (manufactured by Valqua FFT Inc., thickness: 700 µm) with a sputtering apparatus (manufactured by Shibaura Mechatronics Corporation, product name: "CFS-4ES") . An Fe thin film was further formed as a catalyst layer (sputtering gas: Ar, gas pressure : 0.75 Pa, growth rate: 0.012 nm/sec, thickness: 1. 0 nm) on the Al₂O₃ thin film with a sputtering apparatus (manufactured by Shibaura Mechatronics Corporation, product name: "CFS-4ES") .

After that, the flat plate was placed in a quartz tube of 30 mmϕ, and a helium/hydrogen (105/80 sccm) mixed gas having its moisture content kept at 700 ppm was flowed into the quartz tube for 30 minutes to replace the inside of the tube. After that, the temperature in the tube was increased with an electric tubular furnace to 765°C and stabilized at 765°C. While the temperature was kept at 765°C, the inside of the tube was filled with a helium/hydrogen/ethylene (105/80/15 sccm, moisture content: 700 ppm) mixed gas, and the resultant was left to stand for 60 minutes to form a carbon nanotube aggregate on the flat plate.

### [Example 1]

An organic solvent-based ceramic adhesive (manufactured by ThreeBond Co. , Ltd. , product name: "TB3732", binder: metal alkoxide, filler: alumina, solvent: methanol) was applied in a size of a 9.5-millimeter square onto a base material (made of alumina, size: 10 mmx30 mm) with a squeegee.

The carbon nanotube aggregate obtained in Production Example 1 was collected from the flat plate, and was arranged on the applied layer of the adhesive. At this time, the arrangement was performed so that the side of the carbon nanotube aggregate that had been in contact with the flat plate was brought into contact with the applied layer of the adhesive.

After that, a weight of 10 g was placed on the side of the carbon nanotube aggregate opposite to the applied layer of the adhesive via a clean wafer to bring the carbon nanotube aggregate and the applied layer of the adhesive into close contact with each other.

Next, a laminate obtained as described above was placed under normal temperature for 1 hour and under an environment at 100°C for 1 hour to cure the adhesive.

A pressure-sensitive adhesive structure including the base material, a fixing agent layer (thickness: 194 µm), an intermediate layer, and a carbon nanotube aggregate layer (thickness: 440 µm) was obtained as described above. The thickness of the intermediate layer was 30.2 µm.

The resultant pressure-sensitive adhesive structure was subjected to the evaluation (2). The result is shown in Table 1.

### [Example 2]

A pressure-sensitive adhesive structure was obtained in the same manner as in Example 1 except that 20 parts by weight of ethanol was added to 100 parts by weight of the organic solvent-based ceramic adhesive (manufactured by ThreeBond Co., Ltd., product name: "TB3732", binder: metal alkoxide, filler: alumina, solvent: methanol), and then the adhesive was applied to the base material. The thickness of the fixing agent layer of the structure was 152 µm, and the thickness of the carbon nanotube aggregate layer thereof was 526 µm. The thickness of the intermediate layer thereof was 81.4 µm.

The resultant pressure-sensitive adhesive structure was subjected to the evaluation (2). The result is shown in Table 1.

### [Example 3]

An organic solvent-based ceramic adhesive (manufactured by AinCo., Ltd., product name: "RG-57-2-3", binder: organopolysiloxane, inorganic matter: silica, titania, and calcium titanate, solvent: ethylene glycol dibutyl ether) was applied in a size of a 9.5-millimeter square onto a base material (made of alumina, size: 10 mmx30 mm) with a squeegee.

The carbon nanotube aggregate obtained in Production Example 1 was collected from the flat plate, and was arranged on the applied layer of the adhesive. At this time, the arrangement was performed so that the side of the carbon nanotube aggregate that had been in contact with the flat plate was brought into contact with the applied layer of the adhesive.

After that, a weight of 10 g was placed on the side of the carbon nanotube aggregate opposite to the applied layer of the adhesive via a clean wafer to bring the carbon nanotube aggregate and the applied layer of the adhesive into close contact with each other.

Next, a laminate obtained as described above was placed under an environment at 80°C for 30 minutes, under an environment at 150°C for 1 hour, and under an environment at 400°C for 2 hours to cure and calcine the adhesive.

A pressure-sensitive adhesive structure including the base material, a fixing agent layer (thickness: 31 µm), an intermediate layer, and a carbon nanotube aggregate layer (thickness: 1,119 µm) was obtained as described above. The thickness of the intermediate layer was 1.8 µm.

The resultant pressure-sensitive adhesive structure was subjected to the evaluation (2). The result is shown in Table 1.

### [Example 4]

A double-sided pressure-sensitive adhesive tape having a polyimide-based pressure-sensitive adhesive layer was bonded onto a base material (made of alumina, size: 10 mm×30 mm).

The carbon nanotube aggregate obtained in Production Example 1 was collected from the flat plate, and was arranged on the pressure-sensitive adhesive layer. At this time, the arrangement was performed so that the side of the carbon nanotube aggregate that had been in contact with the flat plate was brought into contact with the pressure-sensitive adhesive layer of the double-sided pressure-sensitive adhesive tape.

After that, a weight of 300 g was placed on the side of the carbon nanotube aggregate opposite to the double-sided tape via a clean wafer to bring the carbon nanotube aggregate and the pressure-sensitive adhesive layer into close contact with each other.

A pressure-sensitive adhesive structure including the base material, a fixing agent layer (thickness: 135 µm), an intermediate layer, and a carbon nanotube aggregate layer (thickness: 599 µm) was obtained as described above. The thickness of the intermediate layer was 0.8 µm.

The resultant pressure-sensitive adhesive structure was subjected to the evaluation (2). The result is shown in Table 1.

### [Comparative Example 1]

A pressure-sensitive adhesive structure was obtained in the same manner as in Example 1 except that an adhesive (manufactured by EM Japan Co., Ltd., product name: "G7716", curable component: inorganic silicic acid, filler: carbon, solvent: water) was used instead of the adhesive (manufactured by ThreeBond Co. , Ltd. , product name: "TB3732", binder: metal alkoxide, filler: alumina, solvent: methanol) . The thickness of the fixing agent layer of the structure was 24 µm, and the thickness of the carbon nanotube aggregate layer thereof was 908 µm. The thickness of the intermediate layer thereof was 0.08 µm.

The resultant pressure-sensitive adhesive structure was subjected to the evaluation (2). The result is shown in Table 1.

### [Comparative Example 2]

A pressure-sensitive adhesive structure was obtained in the same manner as in Example 1 except that: an adhesive (manufactured by EM Japan Co., Ltd., product name: "G7716", curable component: inorganic silicic acid, filler: carbon, solvent: water) was used instead of the adhesive (manufacturedby ThreeBond Co., Ltd., product name: "TB3732", binder: metal alkoxide, filler: alumina, solvent: methanol) ; and the weight for bringing the carbon nanotube aggregate and the applied layer of the adhesive into close contact with each other was not used. The thickness of the fixing agent layer of the structure was 30 µm, and the thickness of the carbon nanotube aggregate layer thereof was 616 µm. The thickness of the intermediate layer thereof was 0.05 µm.

**Table 1**

| | Kind of adhesive/pressure-sensitive adhesive | Thickness of intermediate layer (µm) | Durability test |
|---|---|---|---|
| Example 1 | Organic solvent-based ceramic adhesive | 30.2 | No damage |
| Example 2 | Organic solvent-based ceramic adhesive | 81.4 | No damage |
| Example 3 | Organic solvent-based ceramic adhesive | 1.8 | No damage |
| Example 4 | Polyimide-based pressure-sensitive adhesive | 0.8 | No damage |
| Comparative Example 1 | Carbon-based adhesive | 0.08 | Damaged |
| Comparative Example 2 | Carbon-based adhesive | 0.05 | Damaged |

### Reference Signs List

**10** base material
**20** intermediate layer
**30** carbon nanotube aggregate layer
**31** carbon nanotube
**40** fixing agent layer
**100, 200** pressure-sensitive adhesive structure (fixing jig for transportation)

## Claims

1. A pressure-sensitive adhesive structure, comprising:
a base material;
an intermediate layer; and
a carbon nanotube aggregate layer,
wherein the carbon nanotube aggregate layer includes a plurality of carbon nanotube aggregates,
wherein the intermediate layer comprises a layer containing the carbon nanotubes and a fixing agent, and
wherein the intermediate layer has a thickness of 100 nm or more.

2. The pressure-sensitive adhesive structure according to claim 1, further comprising a fixing agent layer between the base material and the intermediate layer.

3. The pressure-sensitive adhesive structure according to claim 2, wherein the fixing agent layer has a thickness of 1 µm or more.

4. The pressure-sensitive adhesive structure according to claim 2 or 3, wherein the fixing agent layer includes an adhesive containing inorganic matter.

5. The pressure-sensitive adhesive structure according to claim 4, wherein the adhesive containing inorganic matter comprises an organic solvent-based ceramic adhesive.

6. The pressure-sensitive adhesive structure according to claim 5, wherein the inorganic matter comprises an inorganic compound containing at least one kind of element selected from the group consisting of Al, Si, Ti, and K.
